(19) **Europäisches Patentamt**
**European Patent Office**
**Office européen des brevets**

(11) **EP 1 903 400 A1**

(12) **EUROPEAN PATENT APPLICATION**

(43) Date of publication:
**26.03.2008 Bulletin 2008/13**

(51) Int Cl.:
***G03F 7/42*** *(2006.01)*

(21) Application number: **06447108.9**

(22) Date of filing: **20.09.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(71) Applicant: **Interuniversitair Microelektronica Centrum**
**3001 Leuven (BE)**

(72) Inventors:
• **Vereecke, Guy**
**1450 Chastre (BE)**

• **Kesters, Els**
**3220 Holsbeek (BE)**
• **Le, Quoc Toan**
**5001 Belgrade**
**Namur (BE)**

(74) Representative: **Bird, Ariane et al**
**Bird Goën & Co**
**Klein Dalenstraat 42A**
**3020 Winksele (BE)**

(54) **A method to remove resist layers from a substrate**

(57) A method for removing a resist layer from a substrate according to the invention, wherein the resist layer comprises bulk resist contacting the substrate and a resist crust being present at the outer surface of the resist layer, comprises the steps of providing at least locally a liquid organic solvent on the resist layer contacting the substrate, for which the bulk resist is soluble in the organic solvent and the resist crust is substantially insoluble in the organic solvent and stripping the resist layer from the substrate by providing megasonic energy to the organic solvent, creating organic solvent cavitations for fracturing the resist crust and dissolving the bulk resist in the organic solvent.

Figure 1

EP 1 903 400 A1

**Description**

**Technical field of the invention**

The present invention relates to methods and apparatus to remove resist layers such as photo resist layers, from a substrate, and to lithographic processes applying such methods to remove resist layers from the substrate.

**Background of the invention**

It is well known in the art of production of semiconductors, that methods are required to strip resists such as photoresists in such a way that resist particles are preferably not left on the substrate after stripping and hence there may be a need for cleaning the resist layer from the substrate.

It is also known that the processing of the substrate provided with a developed resist layer may generate a more rigid resist crust of heavily cross linked and/or doped polymer. The dopants may be provided by e.g. ion bombarding the substrate having a developed resist layer. All along the outer surface of the resist layer, i.e. at the top side of the resist layer as well as along the walls of the trences or vias in the resist layer a resist crust is formed. It is known that these resist crusts are difficult to remove. Similarly, by using reactive ion etching to remove material, such as low-k dielectric materials, a resist crust is formed.

Removing the resist layer using oxygen-containing plasma, also known as ashing, will damage state-of-the-art materials used to manufacture semiconductor devices to the extent that the performance of these devices is deteriorated. These materials include high-k dielectrics such as Hf-silicates, low-k dielectrics such as SiOC or porous dielectrics, metallic gate materials such as fully silicided gate electrodes, TaN, barrier materials such as TaN, W. For example using such an ashing plasma to remove resist which has been implanted with the same high dose as the exposed semiconductor areas, as is done in e.g. Front-End-Of-Line (FEOL) processing when forming junction regions, might cause too much semiconductor material loss in exposed areas. Especially when shallow junction regions are formed, the loss of the doped semiconductor material when removing the resist pattern might result in the removal of the shallow junction region itself. In the Back-End-Of-Line processing, resist removal by plasma ashing might damage the low-k dielectrics such that the effective k-value is degraded.

If the hardened surface resist layer or crust is difficult to remove by conventional methods without damaging the device materials in an unacceptable manner, person skilled in the art will first fragilise the crust in a first process before the actual cleaning step. These pre-treatments can be for example light plasma treatments or cryogenic aerosol spray processes.

US6333268 discloses a method to remove such a resist crust by providing a vapour phase solvent to the substrate having a resist layer with a resist crust at the outer surface of resist bulk, which resist bulk contacts the substrate. The solvent vapour penetrates into the resist crust. After penetration of the solvent vapour, the vapour is condensed and sonic energy is provided to assist the removal of the bulk resist and the resist crust. A plasma treatment prior exposure of the resist layer to the solvent vapour is applied, to remove the bulk resist and much of the resist crust, prior to condensation of the vapour solvent.

This method has some drawbacks. It requires complex process apparatuses, since it requires pressure increasing and adequate pressure control, purge gas after processing, temperature control. Several consecutive steps are to be taken in the same process chamber and the method is very time consuming. The different parameters to be controlled require also a significant energy consumption to provide appropriate process conditions such as temperature and pressure. Precise and simultaneous adjusting and controlling a multitude of process settings is also required. Possibly, particles may remain on the surface of the substrate which have to be removed in a further cleaning process. The high pressure needed to condense solvent on the wafer will require the construction of an expense high-pressure chamber as the process pressure can be very high.

**Summary of the invention**

It is an object of the present invention to provide methods and apparatus for removing resist layer from a substrate whereby the resist layer comprises bulk resist contacting the substrate and a resist crust present at the outer surface of the resist layer. The above objective is accomplished by a method according to the present invention.

An advantage of the method is that it is easier to conduct and is less complex. Another advantage is that the method generates sufficiently clean substrate surfaces, so that additional cleaning operations for removal of remaining particles can be avoided or reduced in extent and complexity.

Another advantage of the invention is that less expensive equipment can be used for removing resist, in particular for resist comprising a hardened surface layer. Another advantage of the invention is that less damage is generated to structures present on the processed substrate while removing the hardened surface resist layer and that the integrity of these substrates or the composing materials is substantially preserved. Another advantage of the invention is that the electrical performance of the devices resulting from the processing is essentially not affected by the resist removing process.

According to the first aspect of the present invention, a method for removing a resist layer from a substrate whereby the resist layer comprises bulk resist contacting the substrate and a resist crust present at an outer surface of the resist layer, comprises:

- providing to the substrate with resist layer at least locally a liquid organic solvent, which organic solvent may comprise a single organic solvent or which organic solvent may comprise a mixture of at least a first and a second organic solvents. The liquid organic solvent is selected form organic solvents so it is adapted to dissolve the bulk resist. The bulk resist is soluble in the organic solvent or organic solvent mixture under process conditions, whereas the resist crust is substantially insoluble in the organic solvent or organic solvent mixture. The organic solvent or organic solvent mixture is selected to dissolve the bulk resist while the resist crust at least partially covering or encapsulating the bulk resist remains substantially intact and attached to the substrate and

- stripping the resist layer, in contact with the organic solvent, from the substrate by providing megasonic energy to the organic solvent creating cavitations in the organic solvent for fracturing the resist crust and dissolving the bulk resist in the organic solvent. The resist layer is removed completely.

The megasonic energy will at least locally be provided. The organic solvent liquid layer is provided at least in the region where megasonic energy locally will be supplied to the substrate. The organic solvent is provided directly as a liquid on the resist layer present on the substrate. Directly providing an organic solvent liquid layer from an organic solvent in liquid phaseto the surface of the resist layer present on the substrate, e.g. a wafer, where resist layer is to be removed, may be done by e.g. spraying, e.g. aerosol spraying, dispensing the liquid organic solvent on the surface, or pouring the liquid on the surface of the resist layer and substrate, or e.g. by dipping the surface of the resist layer and substrate in the solvent liquid. In single wafer cleaning for example only the surface to be processed will be covered with the organic solvent liquid. In batch processing the complete substrate or set of substrate, e.g. the wafer of set of wafers, is immersed into organic solvent liquid.
Due to the cavitations in the organic solvent, the resist crust is fractured into small pieces, of which some may stick to the bulk resist, others being expelled. However, sufficient surface area of the bulk resist is exposed so that the remaining bulk resist on the substrate is dissolved, thereby lifting the remaining resist crust from the surface and removing all bulk resist from the substrate.

The liquid solvent serves not only as medium to generate cavitations and to transport the cavitations towards the resist, but also as a carrying medium to evacuate the resist crust fragments away from the substrate. As a consequence, all particles are removed from the substrate, so a cleaning step is no longer necessary. The resist stripping and surface cleaning is thus done in one process. Hence, process time, energy and labour are reduced. Also less manipulation of the substrate is necessary to provide a cleaned substrate surface.

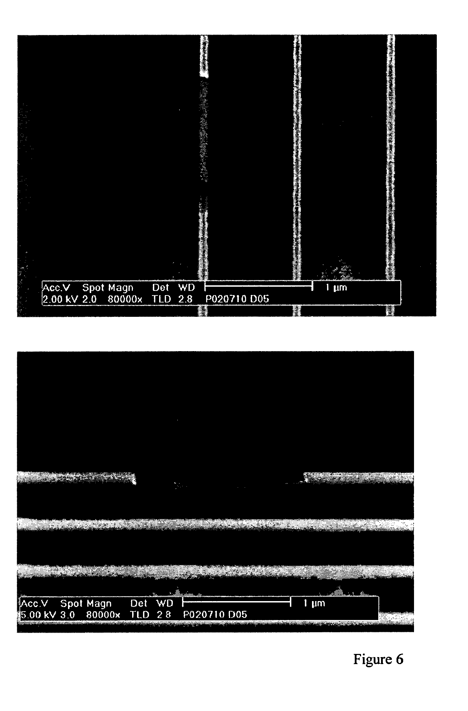

Surprisingly it was found that the cavitations can be well controlled using organic solvents, whereas, as is well known in semiconductor processing, cleaning using ultrasonic cleaning in aqueous liquids, can considerable damage the structures underlying the resist layer. The effect of megasonic cleaning using water is illustrated in figure 6. This figure 6 shows polysilicon lines on a substrate after lithographic processing including removal of the resist. Due to uncontrolled cavitations in the aqueous medium the resist pattern used to pattern the underlying polysilicon layer is removed, but also parts of the polysilicon pattern. Figure 6 shows a damaged polycrystalline line from opposite views: parallel to and perpendicular to the polycrystalline line. This scanning-electron-microscope (SEM) pictures illustrate a characteristic of cavitation-based cleaning: locally the polycrystalline silicon line is completely removed while adjacent portions of this line show no damage at line. The cavitations from organic solvent apparently not only leave the substrate substantially undamaged, but on the other hand cause the resist crust to be fractured, hence help to facilitate the stripping or the resist layer from the substrate. The liquid solvent is allowed to dissolve the bulk resist under the resist crust via the fracture lines or via the free bulk rest areas created by blowing of resist crust fragments.

In case the organic solvent evaporates easily, i.e. in circumstances near process temperature and pressure, the substrate will be dried quickly as well. The resist crust, which is obtained during a device processing step on the substrate during the lithographic process, is usually difficult to remove, especially in case the device processing step comprises an ion bombardment, or a plasma etching such as Reactive Ion Etching, after glow plasma, or any other dry etch removal step. Also thermal treatment steps may cause a hardening of the exposed surfaces of the resist, If, e.g. the resist is heated to temperature of 200°C typically a crust is formed. Using the methods according to the first aspect of the present invention, no expensive and time consuming treatments such as plasma treatment are necessary to fragment and possibly remove the resist crust.

According to some embodiments of the present invention, the process temperature during removing the resist layer from the substrate may be in the range of 0°C to 180°C, more preferred from 20°C to 180 °C

According to some embodiments of the present invention, the process pressure during removing the resist layer from the substrate is the atmospheric pressure, typically at or proportional to room pressure.

According to some embodiments of the present invention, the organic solvent may cavitate at wave frequencies of 0.5 Mhz to 10 Mhz

According to some embodiments of the present invention, the megasonic energy may be provided to the organic solvent during a time period of 0.5 min to 20 min.

According to some embodiments of the present invention, the organic solvent may be selected from the group consisting of cyclohexanone, n-methylpyrrolidone, dichloromethane, methyl isobutyl ketone, trichloroethylene, 1-methoxy-2-propanol, and mixtures of these solvents such as cyclohexanone - dichloromethane 2:1 mixture.

The range of useful organic solvents depends substantially only from the solubility of the bulk resist in the organic solvent in liquid phase. The organic solvent is not necessarily to be able to penetrate through the resist crust. The other process parameters such as temperature, pressure and megasonic energy settings can be adjusted according to the selected solvent to meet the required stripping and cleaning quality.

According to a second aspect of the present invention, a method for lithographic processing of a device comprising a method for removing resist layer from a substrate according to the first aspect of the present invention.

Optionally the method for lithographic processing may further comprise the steps of

- applying a resist layer on a substrate;
- patterning the resist layer by means of irradiating;
- developing the resist layer;
- processing the substrate with the resist layer, thereby generating a resist crust at the outer surface of the resist layer.

Optionally, by irradiating, a resist pattern is created which functions as a protective mask during processing of the substrate.

Optionally processing the substrate comprising the resist layer may be a step chosen from the group consisting of an ion bombardment, a plasma etching such as Reactive Ion Etching, after glow plasma, or any other dry etch removal step Also thermal treatment steps may cause a hardening of the exposed surfaces of the resist, If, e.g. the resist is heated to temperature of 200°C typically a crust is formed.

The use of the method for removing resist layer from a substrate in a lithographic process has the advantage that it reduces the number of actions to be taken and reduces the process time. It also allows removing processed resist at room pressure, i.e. at pressure equal to the pressure in the processing mill, which usually is about atmospheric pressure.

According to a third aspect of the present invention, a semiconductor is processed using a method according to the first and/or the second aspect of the present invention.

The semiconductors according to the third aspect of the present invention have the advantage that they suffer less or not from surface damage due to resist removal operations.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change and evolution of devices in this field, the present concepts are believed to represent substantial new and novel improvements, including departures from prior practices, resulting in the provision of more efficient, stable and reliable devices of this nature.

The teachings of the present invention permit the design of improved methods for lithographic processing of a device, since the methods are more compatible to the use of products having poor compatibility with water or aqueous solutions.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

**Brief description of the drawings**

Fig. 1 is a Scanning Electron Microscope (SEM) photo of Single Damascene (SD) structure after (1) a 20 sec Reactie Ion Etching (RIE) process and (2, 3) a 50 sec. RIE process followed by stripping the resist using megasonic energy with solvent dichloromethane without cavitation of the solvent(2) and solvent n-methylpyrrolidone with cavitation of the solvent (3) according to an embodiment

Fig. 2 are Time-Of-Flight Secondary Mass spectroscopy (ToF-SIMS) depth profiles of blanket PhotoResist (PR) layers: (left) pristine and (right) after 50 sec RIE according to an embodiment.
Fig. 3 are Fourier Transformed Infrared (FTIR) spectra of pristine PR (direct analysis, on-wafer), and, bulk and crust fractions (indirect analysis, off-wafer) of etched PR (35 sec) according to an embodiment.
Fig. 4 shows the dissolution time of pristine PR at room temperature for different commercial solvents given by their Hansen solubility parameters according to an embodiment.
Fig. 5 is view of an incomplete stripped substrate during stripping of the resist according to a step of the method of the first aspect of the present invention according to an embodiment.
Figure 6 is a view of a damaged polysilicon pattern using prior megasonic cleaning process.

In the different figures, the same reference signs refer to the same or analogous elements.

**Description of illustrative embodiments**

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Similarly, it is to be noticed that the term "coupled", also used in the claims, should not be interpreted as being restricted to direct connections only. The terms "coupled" and "connected", along with their derivatives, may be used. It should be understood that these terms are not intended as synonyms for each other. Thus, the scope of the expression "a device A coupled to a device B" should not be limited to devices or systems wherein an output of device A is directly connected to an input of device B. It means that there exists a path between an output of A and an input of B which may be a path including other devices or means. "Coupled" may mean that two or more elements are either in direct physical or electrical contact, or that two or more elements are not in direct contact with each other but yet still co-operate or interact with each other.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

Furthermore, some of the embodiments are described herein as a method or combination of elements of a method that can be implemented by a processor of a computer system or by other means of carrying out the function. Thus, a processor with the necessary instructions for carrying out such a method or element of a method forms a means for carrying out the method or element of a method. Furthermore, an element described herein of an apparatus embodiment is an example of a means for carrying out the function performed by the element for the purpose of carrying out the invention.

In the description provided herein, numerous specific details are set forth. However, it is understood that embodiments of the invention may be practiced without these specific details. In other instances, well-known methods, structures and techniques have not been shown in detail in order not to obscure an understanding of this description.

The following terms are provided solely to aid in the understanding of the invention.

Organic solvent is to be understood as a chemical compound (usually liquid) containing carbon to dissolve another substance (the solute).

Megasonic energy is to be understood as energy provided by acoustic waves being provided to a liquid, having a frequency in the range of 0.5 to 10 MHz.

The term "substrate" may include not only the basic carrier material but also e.g. other materials used in semiconductor processing materials. The basic carrier material may be for example doped or undoped silicon, silicon-on-insulator substrate (SOI), gallium arsenide (GaAs), gallium arsenide phosphide (GaAsP), indium phosphide (InP), germanium (Ge), or silicon germanium (SiGe), glass or quartz substrates.

The substrate is provided with a resist layer, which during lithographic processing, may be patterned by e.g. irradiation, after which the resist is developed. The term developing is to be understood ad? possibly a post-exposure baking step, followed by an etching step, whereby a part of the resist is removed. Depending on the type of resist, i.e. positive or negative resist, the exposed or not exposed resist will be removed by etching. According to the present invention, the "substrate with resist layer" will thereafter be subjected to a device processing of this substrate with the resist layer, thereby generating a resist crust at the outer surface of the resist layer.

The term "resist" is to be understood as material sensitive to irradiation i.e. changes its chemical properties when irradiated; in the form of thin film used as a pattern transfer layer in lithographic processes in semiconductor manufacturing. The resist may be a positive or a negative resist.

The term "resist crust" refers to the resist being present at the outer surface of the resist layer, i.e. at the top side of the resist layer as well as along the walls of the trenches or vias in the resist layer.

The term "bulk resist" refers to the resist material present between the resist crust and the substrate. The bulk resist has the property of being soluble in a given organic solvent under given temperature and pressure. Possibly, however not necessarily, this solubility may be different from the solubility of the resist material applied on the substrate prior to irradiation and developing. The resist crust differs from the bulk resist by being substantially insoluble in the particular solvent under the given temperature and pressure and by adhering to the substrate to the extent that it is not detached by the solvent from the substrate.

The term "stripping" is to be understood as a process in which resist is removed from the surface of the substrate when its is not needed any longer

The term "cleaning" refers to the process of removing contaminants (particles as well as metallic and organic) from the surface of the wafer, in semiconductor processing mainly hydrocarbons from resist/etching processes.

The term "immersing" is to be understood as a process in which substrate is completely immersed in cleaning solutions.

The term "cavitations" is to be understood as a sudden formation and collapse of bubbles in liquids by means of mechanical forces. In particular, this mechanical foirce may be provided by acoustic waves provided to the liquid. Acoustic cavitation occurs whenever a liquid is subjected to sufficiently intense sound with significantly frequency. When sound passes through a liquid, it consists of expansion (negative-pressure) waves and compression (positive-pressure) waves. If the intensity of the sound field is high enough, it can cause the formation, growth, and rapid recompression of vapor bubbles in the liquid. The implosive bubble collapse generates localized heating, a pressure pulse, and associated high-energy chemistry.

Cavitation in liquids can be detected by measuring the sonoluminiscence associated with it. The measurement can be made with a photomultiplier detector.

Organic solvents will be inert to most materials used in semiconductor manufacturing, such as Si, Si02, Si3N4, new high-k gate oxide materials, silicides, metallic gate materials in FEOL, and such as Al, Cu, barrier materials such as SiC, TaN, WCN, dielectric materials such as spin-on glass, low-k dielectric materials in BEOL. Inertness includes non-corrosive to metals such as metal gates, Cu. Present ash processes will damage some of these materials to the extent that ultimate performance of devices are deteriorated. For example removal of highly implanted PR in the FEOL by ash plasma processes causes too much Si loss in areas where the doping profile is very shallow. In the BEOL PR removal by plasma ashing damages the new low-k dielectrics too deeply, thereby increasing the effective integrated k-value. Finally in situations where the crust is difficult to remove by conventional methods without damaging materials in an unacceptable manner, particularly in FEOL, people are considering more and more to first fragilise the crust in some first process before the actual cleaning step. These pre-treatments can be for example light plasma treatments or cryogenic aerosol spray processes. In our invention these pre-treatments are not needed as the physical action of the cavitation is acting simultaneously to the dissolving action of the organic solvent.

It was found that the fragments of the resist crust, obtained by using the method according to the first aspect of the present invention, have characterising sharp edges along the breaking lines. Such fragments may be found still adhering to the substrate surface by means of bulk resist in case the stripping step is not executed completely. The localized character of the breaking and the sharp edges indicate removal by cavitation. This is similar to the breaking e.g. of poly-gate-stack lines by megasonic cleaning in FEOL as shown in Figure 6.

The invention will now be described by a detailed description of several embodiments of the invention. It is clear that other embodiments of the invention can be configured according to the knowledge of persons skilled in the art without departing from the true spirit or technical teaching of the invention, the invention being limited only by the terms of the appended claims.

According to a method for lithographic processing a device, a resist (hereafter referred to as "PR") being a positive methacrylate-based resin for 193-nm lithography, with an adamantane and a lactone as side-groups, to increase etch resistance and adhesion, respectively, is used.

A first specimen, comprising a substrate and the photoresist as such (without any plasma treatment) is referred to as pristine PR.

Two types of specimens, one with and one without pattern, are prepared, a.o. to characterize PR properties after reactive ion etch (RIE). These samples are referred to as plasma treated PR.

For the samples without pattern, the photoresist (30) with a thickness of 330 nm is spin coated onto chemically cleaned p-type [100] silicon substrates (60). Afterwards, a softbake is given at 80°C to evaporate the PR solvent.. The blanket PR coated substrates are etched for 35s or 50s by RIE using a gas mixture containing $O_2$, Ar, $CH_2F_2$ and $CF_4$ to produce the typical RIE-related PR obtained during via/trench etch.

For the samples with pattern, single damascene (SD) BDI low-k structures are etched for 50s under the same RIE process conditions. The two specimens which have a patterned Pr are referred to as blanket PR.

A resist crust is generated by the RIE on the plasma treated PR. GPC (Gel Permeation Chromatography), FTIR (Fourier Transform Infrared), ToF-SIMS (Time of Flight Secondary Ion Mass Spectroscopy), SEM (Scanning Electron Microscopy), NMR (Nuclear Magnetic Resonance) and SS-NMR (solid-state NMR), are applied to characterize photoresist modifications and polymer residues after RIE processing. Both direct, on the wafer, and indirect, off the wafer, analyses of PR layers are performed. For indirect analysis, blanket PR layers with and without plasma treatment are dissolved/suspended in a solvent. In this way, the non-soluble fraction of the top modified layer (or crust) of the etched samples can be separated from the bulk by centrifugation.

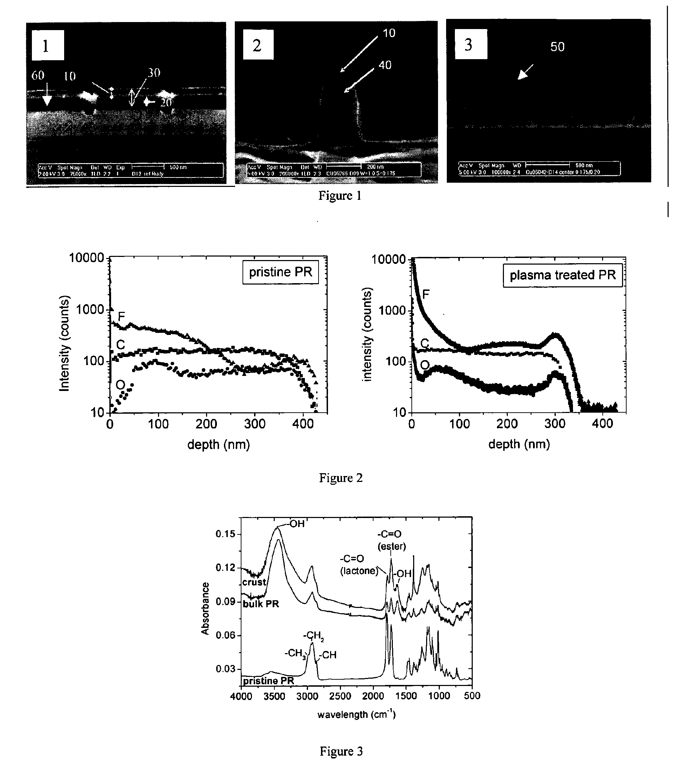

Fig. 1 (1) being a cross section of the plasma treated blanket PR specimen, clearly depicts a crust layer (10) on top of the bulk PR (20) after RIE. Several analyses are performed to reveal compositional differences between crust and bulk PR. ToF-SIMS on blanket PR layers shows the presence of F throughout the entire pristine PR layer (30), due to F-containing additives (Fig. 2 left). After plasma treatment, the top 80 nm of the PR layer, corresponding to the crust observed in SEM, contains a higher F content than the bulk (Fig. 2 right). At opposite to the impression given by SEM pictures, TOF-SIMS data indicates structural changes and modifications of the entire PR layer, also in the bulk. Indirect FTIR analysis (Fig. 3) confirms this statement.

The following major differences after plasma exposure are observed:

1) The peak configuration around 3000 cm$^{-1}$ assigned to C-H vibration absorption changes;
2) the intensity ratio of the peaks at 1795 cm$^{-1}$ (lactone) and 1730 cm$^{-1}$ (ester) assigned to carbonyl (C=O) vibration absorption is reversed; the C=O peak from the lactone group is still less pronounced for the crust sample compared to the bulk;
3) The fingerprint region below 1500 cm$^{-1}$ shows diminished and broadened absorption bands, indicating an increase in molecular weight;
4) The peaks at 1640 and ~3500 cm$^{-1}$ assigned to -OH vibration absorption from $H_2O$ increase, indicating a higher hydrophilicity for both crust and bulk PR compared to the pristine material.

Other results indicate that the increase in molecular weight is related to cross-linking: the magnetization relaxation times and the bandwidths in $^{13}$C SS-NMR are increasing with etching, and the crust is insoluble in the solvents used in GPC analysis (not shown) as well as in all the solvents tested for cleaning (see below). For SS-NMR, crust is collected from 20 blanket etched wafers, giving about 10 mg of sample. However the spectral resolution is still not sufficient to provide new insights in the structural modifications occurring in the crust. The disappearance of a $^{13}$C-signal at 70 ppm, which is corresponding to the C-O from the lactone group, and a decrease of the - $CH_2O$- functionality around

4.4 ppm in the $^1$H-NMR spectra, confirm the FTIR results. Liquid $^1$H-NMR analysis of the fraction of the crust soluble in DMSO (dimethylsulfoxide) at 120 °C of etched blanket PR layers shows the formation of C=C bonds (signal at 5-6 ppm). Based on these results two different cross-linking mechanisms can be proposed. Cross-linking could occur by means of breaking off of the lactone side group along the PR backbone or by ring opening of the lactone group with the formation of free hydroxyl functionalities. In both cases C=C bonds can form and react further on to give cross-linking.

Hence it is clear that there are clear compositional differences between the PR present in the bulk resist and in the resist crust.

For cleaning tests, commercial solvents are first selected in static beaker tests at room temperature of 20°C (RT) based on their ability to dissolve/suspend pristine and etched blanket PR layers. Then cleaning tests on post-etch SD BDI structures are performed on a single wafer (SW) megasonic tool modified to handle organic solvents. PR removal efficiency is assessed by optical microscope and SEM inspection.

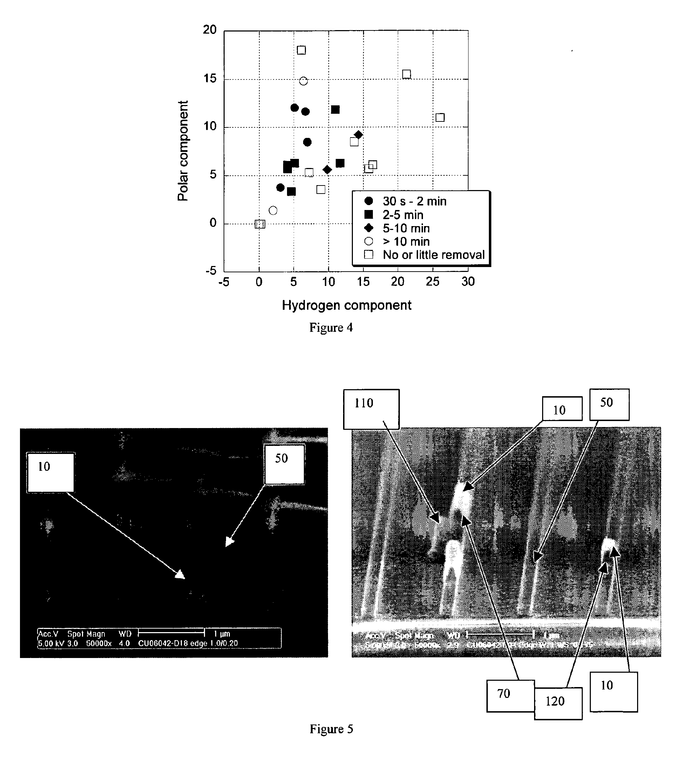

Screening of commercial organic solvents allows to identify several solvents that dissolve the blanket pristine PR in less than 2 min under static condition at room temperature (RT) by immersion of the substrate and resist layer in the solvent. Dissolution times are given in Fig. 4 as a function of Hansen's polar and hydrogen-bonding solubility parameters. Several solvents were tested, however, none of the tested solvents dissolves the blanket plasma modified PR crust, in agreement with characterization showing a crosslinked polymer. A number of organic solvents being able to dissolve the bulk resist were chosen, being cyclohexanone, n-methylpyrrolidone, dichloromethane, methyl isobutyl ketone, trichloroethylene, 1-methoxy-2-propanol, cyclohexanone:dichloromethane 2:1 mixture. The blanket PR specimens were immersed in the chosen solvents. For certain solvents, crust lift-off is observed after 2-5 min exposure with agitation, mostly from dissolution of the bulk layer along the edges of substrate piece, being a wafer pieces.

The chosen solvents were further investigated in cleaning tests on SD patterned BDI structures. With some solvents, as shown in Fig. 1 (2), e.g. dichloromethane and cyclohexanone, megasonic energy was provided (830 kHz, 125 W power supplied to the transducer) for 1-2 min at RT shows only dissolution of the bulk layer, leaving a void (40) while the crust layer (10) formed during plasma etch still remains. On the other hand megasonic energy was provided (830 kHz, 125 W power supplied to the transducer) using other solvents such as n-methylpyrrolidone for 1-2 min at RT shows complete removal of both the bulk and crust PR, as shown in Fig. 1 (3). A completely stripped surface (50) is obtained, from which all resist, both bulk resist and resist crust is removed, i.e. striped. An alternative organic solvent which provided removal of crust was trichloroethylene.

Apparently the organic solvents which were able to strip the bulk resist and the resist crust from the substrate had the properties of being able to dissolve the bulk resist.

The resist crust is substantially insoluble in the organic solvent, i.e. that when the resist crust is brought into contact with the solvent at room temperature, independent of the amount of solvent used, during a time period of 10 min, or even during 15 min or even for 1 hour or more, substantially no resist crust will dissolve in the organic solvent, nor will be brought in suspension. The resist crust may to some extent absorb the liquid organic solvent and possibly may transmit organic solvent through the crust. The possible absorbing of solvent possibly may cause swelling of the resist crust and /or may soften the crust. But the resist crust will not loosen or fall off the substrate. The organic solvent n-methylpyrrolidone used to provide the substrate of Fig. 1 (3) showed cavitation during megasonic cleaning and hence the resist crust could be completely removed, i.e. stripped, from the substrate.

As a consequence, a method for removing resist layer from a substrate whereby the resist comprises bulk resist contacting the substrate and a resist crust being present at the outer surface of the resist layer, comprises the steps of

- Providing at least locally an organic solvent liquid to the resist layer on the substrate for which the bulk resist is soluble in the organic solvent and the resist crust is substantially insoluble in the organic solvent; according to the embodiment as disclosed by means of Fig. 1 to 4, the resist was a methacrylate-based resin for 193-nm lithography, with an adamantane and a lactone as side-groups. The bulk resist after treatment with reactive ion etching technique was found to be soluble in n-methylpyrrolidone at room temperature, whereas the resist crust doesn't dissolve in this organic solvent. The provision of liquid organic solvent may be done by immersing the substrate with positive resist layer in a liquid organic solvent.
- stripping the resist layer from the substrate by providing megasonic energy (frequency of 830 kHz, power of 125 W) to the organic solvent creating organic solvent cavitations for fracturing the resist crust and dissolving the bulk resist in the organic solvent. Cavitation was obtained under room temperature of 20°C and atmospheric pressure above the substrate. The substrate is provided with megasonic energy during a time period of 0.5 to 4 min, in particular 2 min.

The apparatus, in which the method for removing resist layer from a substrate according to the first aspect of the present invention can be carried out, may be a "Goldfinger XT" of the company Goldfinger Technologies, USA, which is modified to enable organic solvent manipulation.

The organic solvent is stored in a canister under N2-pressure of about 2 bar overpressure. The solvent is provided to the cleaning cell by opening appropriate valves at a rate of 0.1 l/min to 1.0 l/min, preferably at 0.5 l/min. Alternatively a pump may be installed between canister and cleaning cell. Via a pipe, the organic solvent is provided to the substrate by means of an exit located above the substrate surface. In such way the organic solvent is provided at least locally to the substrate surface. The pressure drop at the pump outlet and the exit above the substrate may assist in creating bubbles that may assist in creating cavitation of the organic solvent submitted to the acoustic field. A continuous organic solvent flow generated over the substrate provided fresh organic solvent to dissolve the bulk resist, and removes the resist crust fragments which are blown of or lifted from the surface.

At the canister outlet, a 50nm cutoff filter may be applied.

The megasonic energy is provided to the organic solvent at the locaton here organic solvent is present, by means of at least one transmission member, being a quartz cylinder, which is placed horizontally above the rotating substrate, e.g. a wafer, at a distance allowing the solvent film on the wafer to form a meniscus to the surface of the cylinder and wet the quartz cylinder.

The first criterion for effective removal of the resist is the selection of an appropriate organic solvent which dissolves the bulk resist. The second criterion is its ability to create cavitations during provision of megasonic energy, which cavitations limits or even avoids harming the patterned structure. Depending on the choice of possible organic solvents, the other parameters and settings such as process temperature, process pressure, which is preferably atmospheric pressure, process time to apply megasonic energy to the organic solvent, frequency and amplitude or power density, and alike are chosen in order to create cavitation and achieve the required removal of all resist, while avoiding damage to the substrate. The occurrence of cavitation can be detected by observing the removal pattern of partially cleaned patterned wafers. Crust removal by small, sharply cut pieces, is a strong indication for the occurrence of cavitation. Alternatively, sonoluminescence measurements, or by other techniques well known in the field of acoustic science, can be used to detect the occurrence of cavitation. Room temperature is usually preferred, although temperature increase may improve dissolving the bulk resist, but may also influence the creation of cavitation necessary to achieve the removal of the resist crust. By increasing the temperature, the number of cavitation bubbles may be increased, but the energy per bubble is reduced.

The organic solvent chosen may be one particular solvent of may be a mixture of two or more organic solvents, the mixture provided according to the Hansen solubility theory. This concept is well-known in the art and published in C.M. Hansen, Hansen Solubility Parameters: A Users Handbook (CRC Press LLC, 2000).

It is well known that each material in general, and thus a polymer, more particular a bulk resist in particular, can be characterised by three parameter, from the three parameter system developed by Charles M. Hansen in 1966, being

$\delta_{dp}^2$ = dispersion component of polymer;
$\delta_{pp}^2$ = polar component of polymer;
$\delta_{hp}^2$ = hydrogen bonding component of polymer;

and the interaction radius Ro.

A solvent also has Hansen parameters being

$\delta_{ds}^2$ = dispersion component of solvent
$\delta_{ps}^2$ = polar component of solvent
$\delta_{hs}^2$ = hydrogen bonding component of solvent

A polymer is probably soluble in a solvent (or solvent mixture) if the Hansen parameters for the solvent (or solvent mixture) lie within the "solubility sphere" for the polymer, i.e. if Ra is smaller than Ro, where Ra is to be calculated according to the formula:

$$Ra = [4(\delta_{ds} - \delta_{dp})^2 + (\delta_{ps} - \delta_{pp})^2 + (\delta_{hs} - \delta_{hp})^2]^{1/2}$$

It was found that once an appropriate organic solvent was chosen, alternative solvents having Hansen parameters substantially identical to the chosen solvent would as well be applicable to be used in the method according to the first aspect of the present invention.

This method for removing resist layer from a substrate may be used in a method for lithographic processing of a device such as a semiconductor, e.g. a wafer. The lithographic process may further comprises the steps of applying a resist layer, i.e. a resist layer to be developed, to the substrate. The resist may be a positive or negative resist. The resist is then irradiated, e.g. by illuminating with appropriate wavelengths. In such way a pattern may be applied to the resist. The irradiated resist is developed, i.e. baked and etched to remove the uncured resist. Next, processing the substrate with the resist layer is executed, thereby generating a resist crust at the outer surface of the resist layer. This step may be e.g. reactive ion etching, ion bombarding, a plasma etching after glow plasma treatment, a dry etch removal or a thermal treatment or alike. In a following step the method for removing resist layer from a substrate according to the first aspect of the present invention is applied.

Iteration of these steps may be applied to create the different stacks present in a semiconductor.

The use of the method for removing resist layer from a substrate in a lithographic process has the advantage that is reduces the number of actions to be taken and reduces the process time.

According to the third aspect of the present invention, the semiconductor obtained using semiconductor processing such as the lithographic process and/or the method to remove the resist has the advantage that it suffers less or not from surface damage due to cleaning operations. When during application of the method for removing resist layer 30 from a substrate 60, the operation is interrupted, resist crusts 10 which show sharp edges 70 along the cracks and rupture lines may be noticed, as shown in Fig. 5. Remainders of the resist layer 120 may still adhere to the substrate 50, other bulk crust fragments 110 may be noticed which are partially loosened from the substrate.

Other arrangements for accomplishing the objectives of the method for removing resist layer from a substrate whereby the resist comprises bulk resist contacting the substrate and a resist crust being present at the outer surface of the resist layer embodying the invention will be obvious for those skilled in the art.

It is to be understood that although preferred embodiments, specific constructions and configurations, as well as materials, have been discussed herein for devices according to the present invention, various changes or modifications in form and detail may be made without departing from the scope and spirit of this invention. For example, any formulas given above are merely representative of procedures that may be used. Functionality may be added or deleted from the block diagrams and operations may be interchanged among functional blocks. Steps may be added or deleted to methods described within the scope of the present invention.

## Claims

1. A method for removing a resist layer from a substrate whereby the resist layer comprises bulk resist contacting the substrate and a resist crust being present at the outer surface of the resist layer, the method comprises the steps of

   • providing at least locally a liquid organic solvent on the resist layer contacting the substrate, the liquid organic solvent being adapted to dissolve the bulk resist;
   • stripping the resist layer from the substrate by providing megasonic energy to the organic solvent for creating organic solvent cavitations for fracturing the resist crust and dissolving the bulk resist in the organic solvent.

2. A method according to claim 1, wherein the process temperature during removing the resist layer from the substrate is in the range of 20°C to 180 °C

3. A method according to any one of the claims 1 to 2, wherein the process pressure during removing the resist layer from the substrate is room pressure.

4. A method according to any one of the claims 1 to 3, wherein the organic solvent cavitates at wave frequencies of 0.5 to 10 Mhz.

5. A method according to any one of the claims 1 to 4, wherein megasonic energy is provided to the to the organic solvent during a time period of 0.5 min to 20 min.

6. A method according to any one of the claims 1 to 5, wherein the bulk resist has Hansen parameters $\delta_{dp}^2$, $\delta_{pp}^2$ and $\delta_{hp}^2$ and an interaction radius Ro, the organic solvent has Hansen parameters $\delta_{ds}^2$, $\delta_{ps}^2$ and $\delta_{hs}^2$, for which Ra is smaller or equal to Ro, Ra being = $[4(\delta_{ds} - \delta_{dp})^2 + (\delta_{ps} - \delta_{pp})^2 + (\delta_{hs} - \delta_{hp})^2]^{1/2}$

7. A method according to any one of the claims 1 to 6, wherein the organic solvent is selected from the group consisting of cyclohexanone, n-methylpyrrolidone, dichloromethane, methyl isobutyl ketone, trichloroethylene, 1-methoxy-2-propanol, and mixtures of these solvents.

8. A method for lithographic processing of a device comprising the steps of any one of the methods as in claim 1 to 7

9. A method for lithographic processing as in claim 8, further comprising the steps of

   • applying a resist layer on a substrate;
   • patterning the resist layer by means of irradiating;
   • developing the resist layer;
   • processing the substrate with the resist layer, thereby generating a resist crust at the outer surface of the resist layer.

10. A method for lithographic processing as in claim 9, wherein processing the substrate comprising the resist layer is a step chosen from the group consisting of an ion bombardment step, a plasma etching step, a Reactive Ion Etching, an after glow plasma step, a dry etch removal step and a thermal treatment steps.

11. A semiconductor being processed according to a method of claim 1 to 10.

Figure 1

Figure 2

Figure 3

Figure 4

Figure 5

Figure 6

**European Patent Office**

**EUROPEAN SEARCH REPORT**

Application Number

EP 06 44 7108

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 1 536 291 A (DAIKIN IND LTD [JP]) 1 June 2005 (2005-06-01) * paragraphs [0001], [0013], [0014], [0038], [0043], [0137], [0141], [0143], [0145], [0146], [0148], [0152], [0221] - [0225]; examples 54,55,62; table 6 * | 1-11 | INV. G03F7/42 |
| A | JP 2005 340668 A (PUREX KK; MATSUTO IWAO; OMC CO LTD) 8 December 2005 (2005-12-08) * paragraphs [0001], [0014] - [0017], [0021], [0023], [0048], [0055]; claims 1,5,6,9,11,12; figure 3; example 4 * | 1-11 | |
| A | EP 0 846 984 A2 (EKC TECHNOLOGY INC [US]) 10 June 1998 (1998-06-10) * the whole document * | 1-11 | |
| A | US 5 858 106 A (OHMI TADAHIRO [JP] ET AL) 12 January 1999 (1999-01-12) * column 2, line 65 - column 3, line 53; figures 5,7 * * column 10, line 9 - line 34; claims 1,11,13,14 * | 1-11 | TECHNICAL FIELDS SEARCHED (IPC) G03F |
| X | US 2003/108823 A1 (MURAOKA HISASHI [JP] ET AL) 12 June 2003 (2003-06-12) * paragraphs [0002], [0012], [0060], [0158] - [0160]; examples 16,9 * | 1-4,11 | |

The present search report has been drawn up for all claims

| Place of search | Date of completion of the search | Examiner |
|---|---|---|
| Munich | 19 July 2007 | Eggers, Karin |

EPO FORM 1503 03.82 (P04C01)

## ANNEX TO THE EUROPEAN SEARCH REPORT
## ON EUROPEAN PATENT APPLICATION NO.

EP 06 44 7108

This annex lists the patent family members relating to the patent documents cited in the above-mentioned European search report.
The members are as contained in the European Patent Office EDP file on
The European Patent Office is in no way liable for these particulars which are merely given for the purpose of information.

19-07-2007

| Patent document cited in search report | | Publication date | Patent family member(s) | | Publication date |
|---|---|---|---|---|---|
| EP 1536291 | A | 01-06-2005 | AU 2003257636 A1 | | 11-03-2004 |
| | | | CN 1678961 A | | 05-10-2005 |
| | | | WO 2004019134 A1 | | 04-03-2004 |
| | | | KR 20050058448 A | | 16-06-2005 |
| | | | TW 266969 B | | 21-11-2006 |
| | | | US 2006138399 A1 | | 29-06-2006 |
| JP 2005340668 | A | 08-12-2005 | NONE | | |
| EP 0846984 | A2 | 10-06-1998 | NONE | | |
| US 5858106 | A | 12-01-1999 | JP 3690619 B2 | | 31-08-2005 |
| | | | JP 10027771 A | | 27-01-1998 |
| US 2003108823 | A1 | 12-06-2003 | CN 1414610 A | | 30-04-2003 |
| | | | JP 3914842 B2 | | 16-05-2007 |
| | | | JP 2003330206 A | | 19-11-2003 |
| | | | KR 20030033988 A | | 01-05-2003 |
| | | | KR 20050115844 A | | 08-12-2005 |
| | | | TW 584893 B | | 21-04-2004 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

•   US 6333268 B

**Non-patent literature cited in the description**

•   **C.M. HANSEN.** Hansen Solubility Parameters: A Users Handbook. CRC Press, 2000